# EUROPEAN PATENT SPECIFICATION

(11) **EP 0 753 857 B1**
(45) Date of publication and mention of the grant of the patent: **06.02.2002**
(21) Application number: 96110678.8
(22) Date of filing: 02.07.1996
(51) Int. Cl.: G11C 7/00

(54) **Semiconductor memory including an output buffer having a high speed hyper page mode**
Halbleiterspeicher mit einem ultraschnellen Seitenmodusausgangspuffer
Mémoire à semi-conducteurs comprenant un tampon de sortie ayant un mode de page à vitesse très élévée

(30) Priority: 05.07.1995 JP 16969995
(43) Date of publication of application: 15.01.1997
(73) Proprietor: KABUSHIKI KAISHA TOSHIBA, Kawasaki-shi, Kanagawa 212-8572 (JP)
(72) Inventor: Suematsu, Yasuhiro, Tokyo 105 (JP)
(74) Representative: Zangs, Rainer E., Dipl.-Ing.

(56) References cited:
- EP-A- 0 427 286
- EP-A- 0 477 380
- ELECTRONIC ENGINEERING, vol. 66, no. 813, September 1994, LONDON GB, pages 47-48, XP000445400 "HYPER PAGE MODE DRAM"

## Description

The present invention relates to a semiconductor memory device of a type as specified in the preamble of claim 1, including an output buffer circuit.

A semiconductor memory device of such type is disclosed in EP-A-0 427 286.

Preferably, the semiconductor memory device according to the present invention is required to be operated at a high speed.

A hyper page mode (hereinafter referred to as HPM) is one of high speed operation modes of a DRAM. In this mode, when data stored in an internal memory cell or a register is consecutively accessed in accordance with an address signal defined by means of a predetermined clock signal (/CAS: a fall signal of CAS) as a trigger, the accessed data is output, as it is, in a clock cycle between the triggers of a clock signal and the next clock signal. The mode is also called an extended data output mode (EDO).

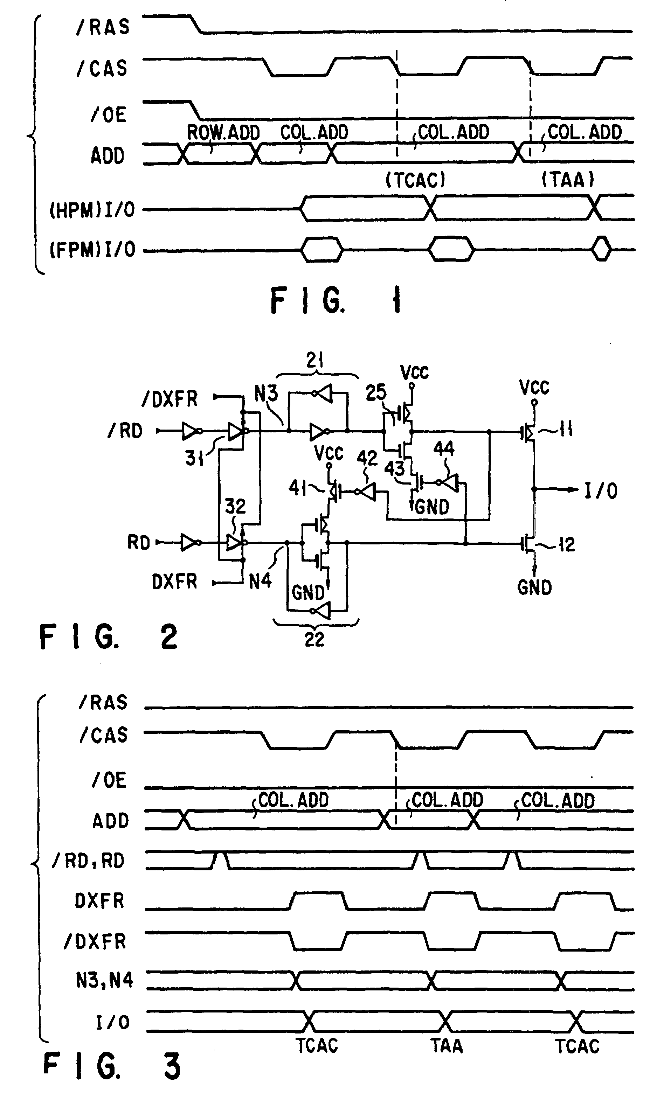

FIG. 1 is a waveform diagram in which data output states in the HPM and the conventional page mode in a DRAM are compared. In this specification, the page mode is called a fast page mode and abbreviated as (FPM). An address signal ADD is divided into a row address (ROW.ADR) and a column address (COL.ADR). The row address is defined by a row selecting signal /RAS (a fall signal of RAS) and the column address is defined by a column selecting signal /CAS (a fall signal of CAS). The column address is consecutively changed, and data in a memory cell (not shown) accessed with the addresses is indicated as an output I/O.

In FIG. 1, the waveform determined by an access time (TCAC) from the signal /CAS and the waveform determined by an access time (TAA) from an address signal are indicated on the same time axis. In the TCAC, data in the corresponding address has already been accessed at the trailing edge of the signal /CAS. On the other hand, in the TAA, since even after the signal /CAS has fallen, data in the corresponding address is accessed, data is defined at a lower speed as compared to the TCAC. Hence, the data definition is slower TAA than in TCAC by this access time, and previous data is continuously output during the access time in the HPM.

As shown in FIG. 1, a data output in the FPM cannot be maintained, when the signal /CAS becomes "H" level. On the other hand, in the HPM, even when the signal /CAS becomes "H" level, a data output is maintained, until memory data of the next address is accessed due to the next fall of the signal /CAS. As the operation frequency of a memory becomes higher and higher, a specification, which is difficult in the FPM, is available in the HPM.

FIG. 2 is a circuit diagram of a conventional output buffer which achieves data output in the HPM of a DRAM. Complementary signals RD and /RD input to an output buffer are data read from a memory cell. Complementary signals DXFR and /DXFR control clocked inverters 31 and 32, thereby controlling transference of the signals RD and /RD to the output buffer.

Data outputs from the clocked inverters 31 and 32 are respectively supplied to latch circuits 21 and 22. Each of the latch circuits is constituted by two inverters, the output of one inverter and the input of the other being connected to each other. An output of the latch circuit 21 is connected to the gate of a P-channel MOS transistor 11 via an inverter 25. An output of the latch circuit 22 is connected to the gate of an N-channel MOS transistor 12. The MOS transistors 11 and 12 are data outputting transistor circuits, and a common drain output of these transistors is connected to a data output I/O.

One of the inverters constituting the latch circuit 22 has a P-channel MOS transistor 41 for controlling a current path to a power source Vcc. An output of the inverter 25 is supplied to the gate of the transistor 41 through an inverter 42. The inverter 25 has an N-channel MOS transistor 43 for controlling a current path to a ground potential GND. An output from the latch circuit 22 is supplied to the gate of the transistor 43 through an inverter 44. These elements serve as a circuit for preventing a through current of the data output transistor circuits.

Gate control of the transistors 11 and 12 is achieved by supplying "H" (high) or "L" (low) level signals to the gates of the transistors. Therefore, current consumption is efficiently reduced by a through current preventing operation in which a Vcc output from the inverter 25 first turns off the P-channel MOS transistor 11 and then turns on the transistor 42 and a Vcc output from the latch circuit 22 turns on the N-channel MOS transistor 12, or a through current preventing operation in which a GND output from the latch circuit 22 first turns off the N-channel MOS transistor 12 and then turns on the transistor 43 and a GND output from the inverter 25 turns on the P-channel MOS transistor 11. The above structure for preventing the through current is particularly significant in a multi-bit product.

FIG. 3 is a waveform diagram illustrating operations of the circuit shown in FIG. 2. Subsequently to the signal /RAS, an address signal in the memory is defined by the fall of the signal /CAS. Data in the memory corresponding to the address signal is transmitted as signals RD and /RD, which are determined after equalizing the "H" level in a data line. The signals DXFR and /DXFR are caused to be "H" level and "L" level respectively, so that new data of the signals RD and /RD are transferred to the output buffer shown in FIG. 2. The new data are output, while latch data previously output in the /CAS cycle is being reset.

The circuit configuration shown in FIG. 2 has the following drawback. In the latch circuits 21 and 22, new data cannot be output, until the output data in the previous cycle has been completely reset by the new data. Hence, the access time is increased, particularly when output data is full swung. In addition, since the through current preventing circuit is provided, the operations of the MOS transistors 11 and 12 at the final stage of the buffer are delayed due to feedback of a signal.

As described above, according to the conventional art, the output buffer having a function of consecutively outputting data in synchronism with a clock signal resets latch data in the previous cycle with newly transferred data. Therefore, it takes a considerable period of time to output desired new data, resulting in prevention of a high-speed access to a semiconductor memory.

The present invention has been made in consideration of the above drawback of the conventional art. It is accordingly an object of the present invention to provide a semiconductor memory having an output buffer, which easily reduces access time.

According to the present invention, this object can be achieved by providing a semiconductor memory device as specified in claim 1.

Improvements thereof are specified in the sub-claims being dependent on claim 1.

A semiconductor memory device according to the present invention may comprise:
a memory cell array in which a plurality of memory cells for storing data are arranged;
transmitting means for transmitting a signal corresponding to data in a memory cell of said memory cell array, which is accessed by an address signal defined in synchronism with a clock signal; and
an output buffer circuit including a data output transistor circuit in which an output corresponding to the data is maintained in a clock cycle determined by the clock signal, the data output transistor circuit, which maintains a first output in a first clock cycle of the clock cycle, being first set to a high-impedance state with a trigger of the clock signal to start a second clock cycle subsequent to the first clock cycle, and then the output buffer fetching new data from the data line when the second clock cycle starts, so that a second output can be obtained.

With the above structure, immediately before an output cycle of new data transmitted from the memory cell through a data line, the previous data is reset by the clock signal. Therefore, high-speed output is achieved.

Preferred embodiments of a semiconductor memory device according to the present invention are described in more detail hereinbelow with reference to the drawings.

In the drawings,
FIG. 1 is a waveform diagram in which data output states in the HPM and the conventional page mode in a DRAM are compared;
FIG. 2 is a circuit diagram of a conventional output buffer which outputs data in the HPM in a DRAM;
FIG. 3 is a waveform diagram illustrating operations of the circuit shown in FIG. 2;
FIG. 4 is a block diagram showing main part of a DRAM according to a first embodiment of the present invention;
FIG. 5 is a circuit diagram showing the structure of an output buffer according to a second embodiment of the present invention;
FIG. 6 is a waveform diagram illustrating operations of the circuit shown in FIG. 5;
FIG. 7 is a circuit diagram showing the structure of an output buffer according to a third embodiment of the present invention;
FIG. 8 is a circuit diagram showing the structure of an output buffer according to a fourth embodiment of the present invention; and
FIG. 9 is a waveform diagram illustrating evaluation of the output state in the HPM according to the present invention.

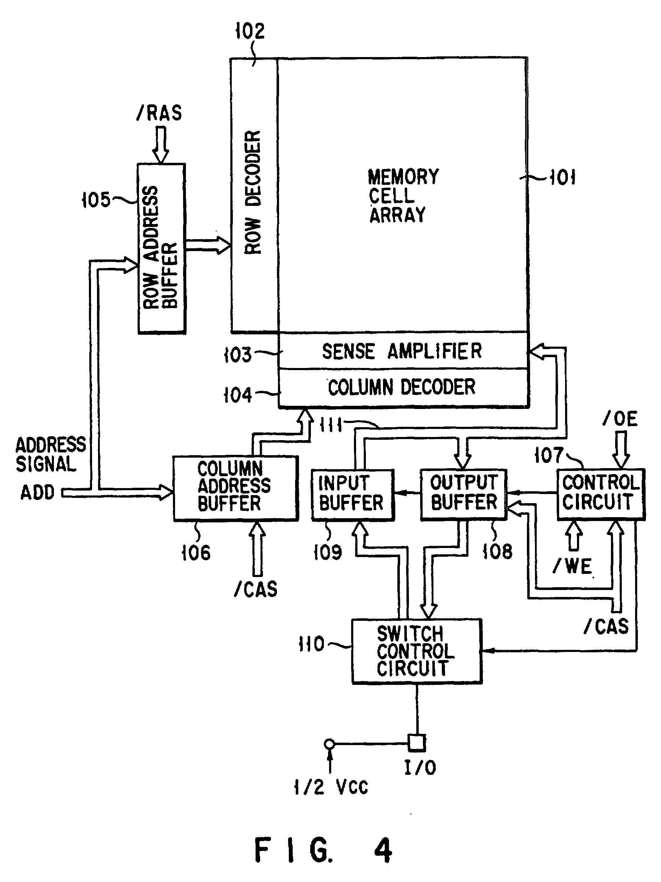

FIG. 4 is a block diagram showing main part of a DRAM according to a first embodiment of the present invention.

A memory cell array 101 comprises a plurality of memory cells for storing data. A row decoder 102, a sense amplifier 103 and a column decoder 104 constitute a memory core section used to read or write data in or from the memory cell or to refresh data in response to an address signal. The address signal is output from a row address buffer 105 and a column address buffer 106, to which /RAS (a fall signal of RAS) and /CAS (a fall signal of CAS) are respectively input. A control circuit 107 receives /WE (a fall signal of WE) of a write enable signal, /OE (a fall signal of OE) of an output enable signal, the signal /CAS and so on, and controls an output buffer 108, an input buffer 109 and a switch control circuit 110 which electrically switches these buffers so as to be connected to an output I/O. The output I/O can be clamped in a power source 1/2 Vcc via, for example, an external circuit, during a floating time when the output potential is unstable.

The above structure is characterized in a reading operation for realizing data output in the HPM. More specifically, data stored in a memory cell in the memory cell array 101 or a register provided in the column direction (e.g., a sense amplifier) is consecutively accessed using an external clock signal, e.g., the signal /CAS, as a trigger. The accessed data is output as it is through the output buffer 108 in a clock cycle between the trigger of the signal /CAS and the next trigger. The semiconductor memory thus constructed, in which the signal /CAS is supplied to the output buffer 108, contributes to data output control.

In the output buffer 108, data is reset by the signal /CAS, just before an output cycle of new data output through a data line 111 from a memory cell. Since immediately thereafter, new data is supplied through the data line 111 to the output buffer, a high-speed output operation is realized.

The structure of the output buffer 108 will be described in detail.

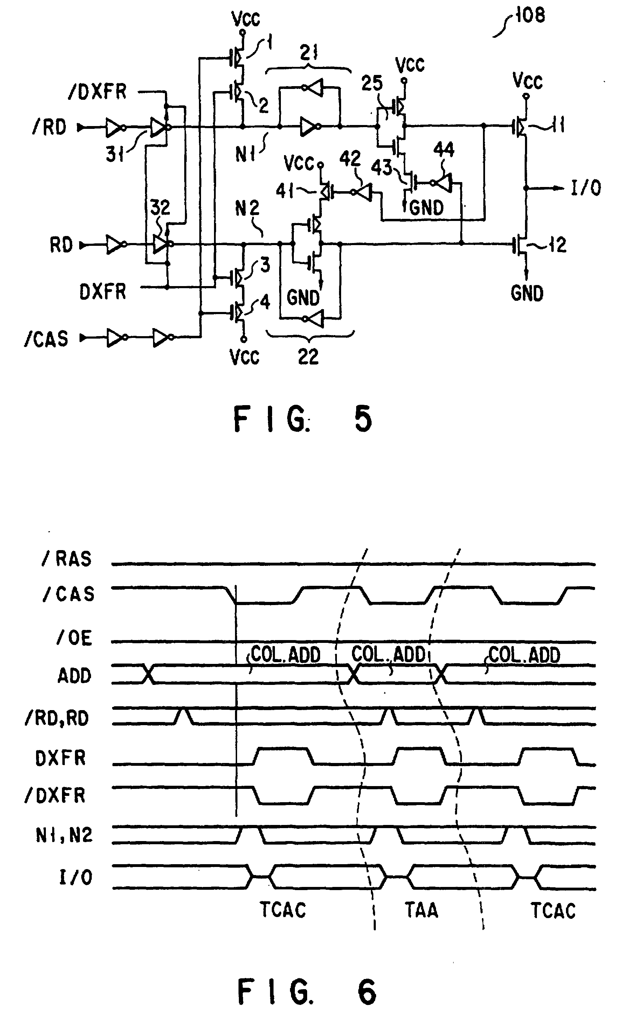

FIG. 5 is a circuit diagram showing the structure of an output buffer according to a second embodiment of the present invention. The circuit of FIG. 5 is different from that of FIG. 2 in that a signal /CAS of an external clock signal is introduced and an output of a logical circuit, like a NAND gate, of signals /CAS and DXFR (a data transfer control signal) is supplied to nodes N1 and N2. More specifically, current paths of P-channel MOS transistors 1 and 2 are formed in series between a power source Vcc and the node N1 of the transmission lines of the clocked inverter 31 and the latch circuit 21. Current paths of P-channel MOS transistors 3 and 4 are formed in series between the power source Vcc and the node N2 of the transmission lines of the clocked inverter 32 and the latch circuit 22. The signal /CAS is supplied to the gates of the transistors 1 and 4, and the signal DXFR is supplied to the gates of the transistors 2 and 3. The other elements are the same as those of the circuit shown in FIG. 2, and identified by the same reference numerals as those in FIG. 2. The clocked inverters 31 and 32 for transferring and controlling signals RD and /RD of data read from a memory cell are activated when the signal DXFR becomes "H" level and the signal /DXFR becomes "L" level. Signal data of /RD and RD are respectively supplied to the latch circuits 21 and 22. Each of the latch circuits 21 and 22 is constituted by two inverters, the output of one inverter and the input of the other being connected to each other. An output of the latch circuit 21 is connected to the gate of a P-channel MOS transistor 11 via an inverter 25. An output of the latch circuit 22 is connected to the gate of an N-channel MOS transistor 12. The MOS transistors 11 and 12 are data outputting transistor circuits, and a common drain output of these transistors is connected to a data output I/O. One of the inverters constituting the latch circuit 22 has a P-channel MOS transistor 41 for controlling a current path to a power source Vcc. An output of the inverter 25 is supplied to the gate of the transistor 41 through an inverter 42. The inverter 25 has an N-channel MOS transistor 43 for controlling a current path to a ground potential GND. An output from the latch circuit 22 is supplied to the gate of the transistor 43 through an inverter 44. These elements serve as a circuit for preventing a through current of the data output transistor circuits (11, 12), as described before with reference to FIG. 2.

FIG. 6 is a waveform diagram illustrating operations of the circuit shown in FIG. 5. Subsequently to the signal /RAS, an address signal in the memory is defined by the fall of /CAS. Data in the memory corresponding to the address signal is transmitted as signals RD and /RD, which are determined after equalizing the "H" level in a data line. Immediately after the fall of the signal /CAS, the signals DXFR and /DXFR respectively become "L" level and "H" level (the levels of signals immediately before the clock cycle which is to start upon fall of the signal /CAS), and the clocked inverters 31 and 32 are in an non-operating state. In this state, P-channel transistors 1 to 4 are turned on by the "L" level of the signal /CAS and the "L" level of the signal DXFR. As a result, both the nodes N1 and N2 become "H" level, thereby resetting latch data in the latch circuits 21 and 22. At the same time, "H" and "L" level signals are respectively applied to the gates of the P-channel and N-channel MOS transistors 11 and 12 (the data output transistor circuits), thereby turning off the transistors 11 and 12. Consequently, the output of the data output transistor circuit becomes a high-impedance state (1/2 Vcc). Thereafter, the signals DXFR and /DXFR respectively become "H" and "L" levels, so that the clocked inverters 31 and 32 are operated, thereby transferring new data RD and /RD to the nodes N2 and N1. In this time, since the signal DXFR is "H" level, the transistors 2 and 3 are off. Since it is only necessary that the new data RD and /RD turn either the latch circuit 21 or 22 to "L" level, the data setting speed in the latch circuits 21 and 22 is increased.

In FIG. 6, as in FIG. 3, the waveform determined by an access time (TCAC) from /CAS and the waveform determined by an access time (TAA) from an address signal are indicated on the same time axis. The portion of TAA is roughly marked off by broken lines. With the above structure, first data is maintained by the latch circuits 21 and 22 in a first reading period in a first /CAS cycle. Then, the data output transistor circuit (the MOS transistors 11 and 12) which outputs data in accordance with the first data, is set in a high-impedance state utilizing a trigger of a leading edge of the signal /CAS to start a second reading period in a second /CAS cycle after the first reading period. At the same time, the latch circuits 21 and 22 are reset at the leading edge of the signal /CAS in the second /CAS cycle. Then, the second reading period starts upon change of the levels of signals DXFR and /DXFR. As a result, second data (signals RD and /RD) are latched by the latch circuits 21 and 22, and new data corresponding to the second data are output from the data output transistor circuit.

Since the latch circuits 21 and 22 have been reset with a trigger of the signal /CAS before new data are transferred and the data output transistor circuits (11, 12) are set to a high-impedance state, it is unnecessary to wait the data output transistor (11 or 12) to be turned off. Hence, the access time from the fall of the signal /CAS can be reduced. Consequently, even if the operation frequency of the memory is increased as compared to that in the conventional HPM, a high-speed access operation can easily be performed.

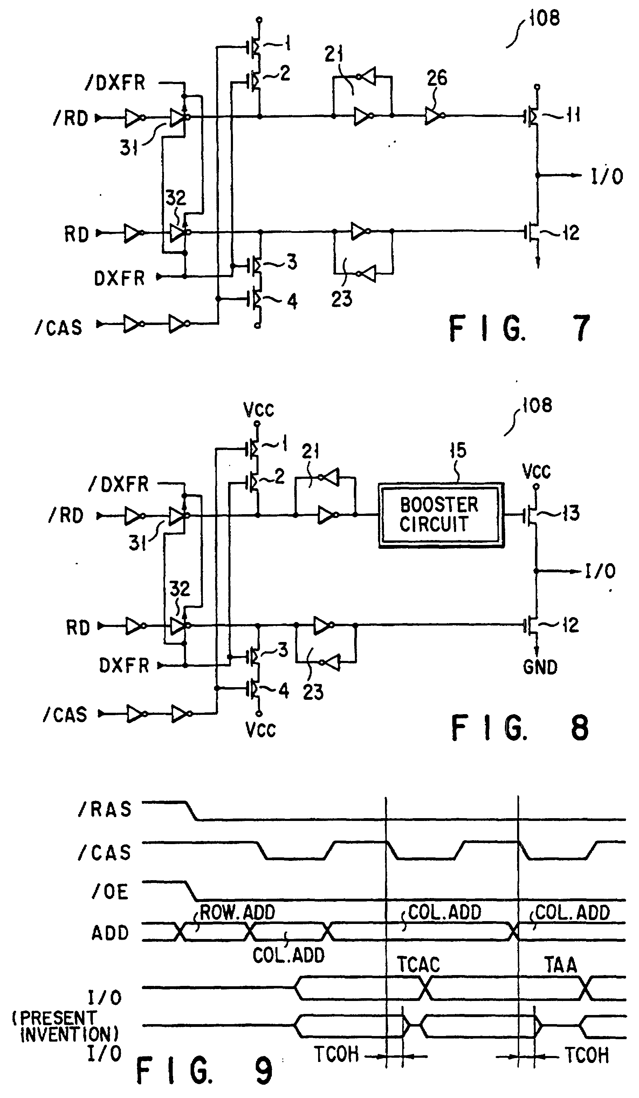

FIG. 7 is a circuit diagram showing the structure of an output buffer according to a third embodiment of the present invention. The structure is different from that of FIG. 5 in that the circuit for preventing a through current is not provided. Since the latch circuits 21 and 22 have been reset with a trigger of the signal /CAS before new data are transferred and the data output transistor circuits (11, 12) are set to a high-impedance state, no circuit for preventing a through current is required. Thus, the critical path for data transfer can be shortened to minimum, thereby achieving an access operation at a higher speed. However, when the operation frequency of the memory is increased as high as possible so long as the memory is accessible, it requires less time to set the data output transistors (11, 12). In this case only, the circuit as shown in FIG. 5 is more stable than that as shown in FIG. 7.

FIG. 8 is a circuit diagram showing the structure of an output buffer according to a fourth embodiment of the present invention. The structure is different from that of FIG. 5 in data output transistor circuits (13, 12). The data output transistor circuits (11, 12) shown in FIG. 7 are CMOS transistor circuits, whereas the data output transistor circuits shown in FIG. 8 are both N-channel transistor circuits. More specifically, the P-channel MOS transistor 11 in FIG. 7 is replaced with an N-channel MOS transistor 13, which can be driven at a higher speed than a P-channel MOS transistor. As a result, the inverter 26 shown in FIG. 7 is not required logically. Instead, voltage drop in an amount of threshold voltage must be taken into consideration, that is, an ON voltage, which is increased at least in an amount of the threshold voltage of the transistor 13, is required to turn on the N-channel MOS transistor 13. For this purpose, a booster circuit 15 is provided to boost the gate voltage of the transistor 13 in a data pull-up output time in the transistor circuits (13, 12). The above structure, like the structure as shown in FIG. 7, allows the critical path for data transfer to be shortened to minimum, and the data output transistor to be driven at a higher speed, thus contributing to a high-speed access operation of the memory.

FIG. 9 is a waveform diagram illustrating evaluation of the output state in the HPM according to the present invention, in which the output state of the present invention is compared with that of the circuit shown in FIG. 2. In Fig. 9, TCOH denotes a command hold time, which evaluates the length of a period of maintaining data from the "H" edge before the "L" level, i.e., the end of the /CAS cycle. According to the present invention, before new data is supplied, the latch circuits in the output buffer circuit is reset utilizing a trigger of the signal /CAS for the new data and the output of the data output transistor circuits becomes a high impedance state (1/2 Vcc). Thus, since the data output transistor does not output any data when the signal /CAS falls to "L" level, the data output maintaining period is reduced as compared to that of the conventional art. However, since the length of TCOH is maintained so as not to influence both TCAC and TAA, the reduction of the data output maintaining period causes no problem. In addition, since an output of the data output transistor circuit is clamped in 1/2 Vcc (high impedance state) before outputting new data, the time required to start data output is reduced as compared to the conventional art.

Although the above description is limited to the operation state in the HPM of the DRAM, the present invention is not limited thereto. For example, the clock signal need not be /CAS but can be any clock signal generated in the memory. The present invention is applicable to a semiconductor memory which can be successively accessed by using a clock signal as a trigger and which can output the accessed data as it is in a cycle between the trigger of a clock signal and the trigger of a next clock signal.

## Claims

1. A semiconductor memory device, comprising
a memory cell array (101) in which a plurality of memory cells for storing data are arranged;
transmitting means (102, 103, 104, 105, 106, 107) for transmitting a signal corresponding to data in a memory cell of said memory cell array (101), which is accessed by an address signal defined in synchronism with a clock signal; and
an output buffer circuit (108) including a data output transistor circuit (11, 12; 13, 12) in which an output corresponding to the data is maintained in a clock cycle determined by the clock signal (/CAS);
***characterized in that***
said data output transistor circuit (11, 12; 13, 12) which maintains a first output in a first clock cycle of the clock signal (/CAS), is first set to a high-impedance state with a trigger of the clock signal (/CAS) in a second clock cycle before starting of a reading period in the second clock cycle, and then said output buffer circuit (108) fetches new data from the data line (/RD,RD) when the reading period starts in the second clock cycle so that a second output can be obtained.

2. The semiconductor memory device according to claim 1, wherein the clock signal (/CAS) is supplied from an outside of the semiconductor memory device.

3. The semiconductor memory device according to claim 1 or 2, wherein the output buffer circuit (108) comprises a transfer control circuit (31, 32), provided between the data line (111) and the output buffer circuit, for transferring a signal transmitted through the data line to the data output transistor circuit (11, 12; 13, 12), the transfer control circuit being controlled by a second clock signal (/DXFR, DXFR).

4. The semiconductor memory device according to claim 3, wherein the output buffer circuit (108) sets the data output transistor circuit (11, 12; 13, 12) to a high-impedance state and resets data corresponding to an output which has been maintained in the circuit (108), by logical output means (1, 2, 3, 4) utilizing the trigger of the clock signal and the second clock signal (/DXFR, DXFR) in a clock cycle immediately before the clock cycle to be started by the trigger.

5. The semiconductor memory device according to claim 4, wherein the logical output means (1, 2, 3, 4) connect a logical output to a transmission line between the transfer control circuit (31, 32) and the data output transistor circuit (11, 12; 13, 12), and transmit a signal to set the data output transistor circuit (11, 12) to a high-impedance state during a period between the trigger of the clock signal and a time when the transfer control circuit (31, 32) is activated.

6. The semiconductor memory device according to any of the preceding claims, wherein the data output transistor circuit (11, 12) is a CMOS transistor circuit (11, 12).

7. The semiconductor memory device according to claim 6, wherein the output buffer circuit (108) includes first and second latch circuits (21, 22) for maintaining an output from the data output transistor circuit (11, 12), each latch circuit being constituted by two inverters such that an output of one inverter and an input of the other being connected to each other, an output of the first latch circuit (21) being connected to a gate of a P-channel MOS transistor (11) of the CMOS transistor circuit via an inverter (25), and an output of the second latch circuit (22) being connected to a gate of an N-channel MOS transistor (12) of the CMOS transistor circuit.

8. The semiconductor memory device according to any one of claims 1 to 5, wherein the data output transistor circuit (13, 12) is an N-channel MOS transistor circuit (13, 12).

9. The semiconductor memory device according to claim 8, wherein the output buffer circuit includes first and second latch circuits (21, 23) for maintaining an output from the data output transistor circuit (13, 12), each latch circuit being constituted by two inverters such that an output of one inverter and an input of the other being connected to each other, an output of the first latch circuit (21) being connected to a gate of a transistor (13) of a pull-up side of the N-channel MOS transistor circuit, and an output of the second latch circuit (23) being connected to a gate of a transistor (12) of a pull-down side of the N-channel MOS transistor circuit.

10. The semiconductor memory device according to claim 9, wherein the output buffer circuit (108) includes boosting means (15) for boosting a gate voltage of the transistor (13) of the pull-up side of the N-channel MOS transistor in a data pull-up output operation of the data output transistor circuit (13, 12).

11. The semiconductor memory device according to claim 6 or 8, wherein the output buffer circuit (108) comprises circuit means (41, 42, 43, 44) for preventing a through current of the data output transistor circuit.

12. The semiconductor memory device according to any of the preceding claims, wherein an output of the data output transistor circuit (11, 12; 13, 12) is clamped in an intermediate level of an output logical level, when the data output transistor circuit (11, 12; 13, 12) is in the high-impedance state.

## Patentansprüche

1. Halbleiter-Speichervorrichtung, umfassend
ein Speicherzellenfeld (101), in welchem mehrere Speicherzellen zur Speicherung von Daten angeordnet sind;
eine Übertragungseinrichtung (102, 103, 104, 105, 106, 107) zum Übertragen eines Signals entsprechend Daten in einer Speicherzelle des Speicherzellenfeldes (101), auf welche durch ein Adress-Signal zugegriffen wird, das synchron zu einem Taktsignal definiert wird; und
eine Ausgangs-Pufferschaltung (108) mit einer Daten-Ausgangstransistorschaltung (11, 12; 13, 12), in welcher ein den Daten entsprechendes Ausgangssignal in einem Taktzyklus gehalten wird, der durch das Taktsignal (/CAS) bestimmt ist;
***dadurch gekennzeichnet, dass***
die Daten-Ausgangstransistorschaltung (11, 12; 13, 12), welche ein erstes Ausgangssignal in einem ersten Taktzyklus des Taktsignals (/CAS) hält, zunächst in einen Hoch-Impedanz-Status gesetzt wird mit einem Trigger des Taktsignals (/CAS) in einem zweiten Taktzyklus, bevor eine Zeitspanne zum Auslesen in dem zweiten Taktzyklus gestartet wird, und dann die Ausgangs-Pufferschaltung (108) neue Daten aus der Datenleitung (/RD, RD) holt, wenn die Lese-Zeitspanne in dem zweiten Taktzyklus startet, so dass ein zweites Ausgangssignal erhalten werden kann.

2. Halbleiter-Speichervorrichtung nach Anspruch 1, bei welcher das Taktsignal (/CAS) von außen an die Halbleiter-Speichervorrichtung geliefert wird.

3. Halbleiter-Speichervorrichtung nach Anspruch 1 oder 2, bei welcher die Ausgangs-Pufferschaltung (108) eine Übertragungssteuerschaltung (31, 32) aufweist, die zwischen der Datenleitung (111) und der Ausgangs-Pufferschaltung angeordnet ist, zum Übertragen eines Signals, das durch die Datenleitung an die Daten-Ausgangstransistorschaltung (11, 12; 13, 12) übertragen wird, wobei die Übertragungssteuerschaltung durch ein zweites Taktsignal (/DXFR, DXFR) gesteuert wird.

4. Halbleiter-Speichervorrichtung nach Anspruch 3, bei welcher die Ausgangs-Pufferschaltung (108) die Daten-Ausgangstransistorschaltung (11, 12; 13, 12) in einen Hoch-Impedanz-Status setzt and Daten, die einem in der Schaltung (108) gehaltenen Ausgangssignal entsprechen, zurücksetzt durch eine Logiksignal-Ausgangseinrichtung (1, 2, 3, 4) unter Verwendung des Triggers des Taktsignals und des zweiten Taktsignals (/DXFR, DXFR) in einem Taktzyklus unmittelbar vor dem durch den Trigger zu startenden Taktzyklus.

5. Halbleiter-Speichervorrichtung nach Anpruch 4, bei welcher die logische Ausgangsschaltung (1, 2, 3, 4) einen logischen Ausgang an eine Übertragungsleitung zwischen der Übertragungssteuereinrichtung (31, 32) und der Daten-Ausgangstransistorschaltung (11, 12; 13, 12) anschließt und ein Signal überträgt zum Setzen der Daten-Ausgangstransistorschaltung (11, 12) in einen Hoch-Impedanz-Status während einer Zeitspanne zwischen dem Trigger des Taktsignals und einer Zeit, wenn die Übetragungssteuerschaltung (31, 32) aktiviert wird.

6. Halbleiter-Speichervorrichtung nach einem der vorangehenden Ansprüche, bei welcher die Daten-Ausgangstransistorschaltung (11, 12) eine CMOS-Transistorschaltung (11, 12) ist.

7. Halbleiter-Speichervorrichtung nach Anspruch 6, bei welcher die Ausgangs-Pufferschaltung (108) erste und zweite Verriegelungsschaltungen (21, 22) enthält zum Halten eines Ausgangssignals aus der Daten-Ausgangstransistorschaltung (11, 12), wobei jede Verriegelungschaltung durch zwei Inverter gebildet ist derart, dass ein Ausgang des einen Konverters und ein Eingang des anderen Inverters miteinander verbunden sind, ein Ausgang der ersten Verriegelungsschaltung (21) an ein Gate eines P-Kanal-MOS-Transistors (11) der CMOS-Transistorschaltung über einen Inverter (25) angeschlossen ist, und ein Ausgang der zweiten Verriegelungsschaltung (22) an ein Gate eines N-Kanal-MOS-Transistors (12) der CMOS Transistorschaltung angeschlossen ist.

8. Halbleiter-Speichervorrichtung nach einem der Ansprüche 1 bis 5, bei welcher die Daten-Ausgangstransistorschaltung (13, 12) eine N-Kanal-MOS-Transistorschaltung (13, 12).

9. Halbleiter-Speichervorrichtung nach Anspruch 8, bei welcher die Ausgangs-Pufferschaltung erste und zweiten Verriegelungsschaltungen enthält zum Halten eines Ausgangssignals aus der Daten-Ausgangstransistorschaltung (13, 12), wobei jede Verriegelungsschaltung durch zwei Inverter gebildet darart, dass ein Ausgang eines der Inverter und ein Eingang des anderen Inverters miteinander verbunden sind, ein Ausgang der ersten Verriegelungsschaltung (21) an ein Gate eines Transistors (13) einer "Pull-up"-Seite der N-Kanal-MOS-Transistorschaltung angeschlossen ist, und ein Ausgang der zweiten Verriegelungsschaltung (23) an ein Gate eines Trasistors (12) einer "Pull-down"-Seite der N-Kanal-MOS-Transistorschaltung angeschlossen ist.

10. Halbleiter-Speichervorrichtung nach Anspruch 9, bei welcher die Ausgangs-Pufferschaltung (108) eine Booster-Einrichtung (15) zum Boosten einer Gatespannung des Transistors (13) auf der "Pull-up"-Seite des N-Kanal- MOS-Transistorsi transistor in einer Daten-"Pull-up"-Ausgangsoperation der Daten-Ausgangstransistorschaltung (13, 12).

11. Halbleiter-Speichervorrichtung nach Anspruch 6 oder 8, bei welcher die Ausgangs-Pufferschaltung (108) eine Schaltungsanordnung (41, 42, 43, 44) aufweist zur Verhinderung eines Stromdurchschlags in der Daten-Ausgangstransistorschaltung.

12. Halbleiter-Speichervorrichtung nach einem der vorangehenden Ansprüche, bei welcher ein Ausgang der Daten-Ausgangstransistorschaltung (11, 12; 13, 12) auf einen mittleren Pegel eines Ausgangs-Logik-Pegels festgelegt ist, wenn die Daten-Ausgangstransistorschaltung (11, 12; 13, 12) in dem Hoch-Impedanz-Status ist.

## Revendications

1. Dispositif de mémoire à semiconducteurs, comprenant
un réseau (101) de cellules de mémoire, dans lequel une pluralité de cellules de mémoire sont disposées pour la mémorisation de données;
des moyens de transmission (102, 103, 104, 105, 106, 107) servant à transmettre un signal correspondant à des données dans une cellule de mémoire dudit réseau (101) de cellules de mémoire, dans lequel l'accès est réalisé par un signal d'adresse défini en synchronisme avec le signal d'horloge, et
un circuit tampon de sortie (108) comprenant un circuit à transistor de sortie de données (11, 12; 13, 12) dans lequel un signal de sortie correspondant aux données est conservé dans un cycle d'horloge déterminé par le signal d'horloge (/CAS);
**caractérisé en ce que**
ledit circuit à transistors de sortie de données (11, 12; 13), qui maintient un premier signal de sortie dans un premier cycle d'horloge du signal d'horloge (/CAS), est tout d'abord réglé sur un état d'impédance élevée, avec un déclenchement du signal d'horloge (/CAS) dans un second cycle d'horloge avant le démarrage d'une période de lecture dans le second cycle d'horloge, puis ledit circuit tampon de sortie (108) extrait de nouvelles données à partir de la ligne de transmission de données (/RD, RD), lorsque la période de lecture commence dans le second cycle d'horloge de sorte qu'un second signal de sortie peut être obtenu.

2. Dispositif de mémoire à semiconducteurs selon la revendication 1, dans lequel le signal d'horloge (/CAS) est délivré à partir de l'extérieur du dispositif de mémoire à semiconducteurs.

3. Dispositif de mémoire à semiconducteurs selon la revendication 1, dans lequel le circuit formant tampon de sortie (108) comprend un circuit de commande de transfert (31, 32), prévu entre la ligne de transmission de données (111) et le circuit tampon de sortie, pour transférer un signal transmis par la ligne de transmission de données au circuit à transistors de sortie de données (11, 12; 13), le circuit de commande de transfert étant commandé par un second signal d'horloge (/DXFR, DXFR).

4. Dispositif de mémoire à semiconducteurs selon la revendication 3, dans lequel le circuit tampon de sortie (108) règle le circuit à transistors de sortie de données (11, 12; 13, 12) sur un état d'impédance élevée et ramène à l'état initial des données correspondant à un signal de sortie qui a été maintenu dans le circuit (108), à l'aide de moyens de sortie logiques (1, 2, 3, 4) définissant le déclenchement du signal d'horloge et le second signal d'horloge (/DXFR, DXFR) dans un cycle d'horloge situé juste avant le cycle d'horloge devant être déclenché par le déclencheur.

5. Dispositif de mémoire à semiconducteurs selon la revendication 4, dans lequel les moyens de sortie logiques (1, 2, 3, 4) connectent une sortie logique à une ligne de transmission entre le circuit de commande de transfert (31, 32) et le circuit à transistors de sortie de données (12, 13; 12) et transmettent un signal pour régler le circuit à transistors de sortie de données (11, 12) sur un état d'impédance élevée pendant une période s'étendant entre le déclenchement du signal d'horloge et un instant où le circuit de commande de transfert (31, 32) est activé.

6. Dispositif de mémoire à semiconducteurs selon l'une quelconque des revendications précédentes, dans lequel le circuit à transistors de sortie de données (11, 12) est un circuit à transistors CMOS (11, 12).

7. Dispositif de mémoire à semiconducteurs selon la revendication 6, dans lequel le circuit tampon de sortie (108) comprend des premier et second circuits de verrouillage (21, 22) pour conserver un signal de sortie délivré par le circuit à transistors de sortie de données (11, 12), chaque circuit de verrouillage étant constitué de deux inverseurs de telle sorte qu'une sortie d'un inverseur et une entrée de l'autre inverseur sont connectées entre elles, une sortie du premier circuit de verrouillage (21) étant connectée à une grille d'un transistor MOS à canal P (11) du circuit à transistors CMOS par l'intermédiaire d'un inverseur (25), et une sortie du second circuit de verrouillage (22) étant connectée à une grille d'un transistor MOS à canal N (12) du circuit à transistors CMOS.

8. Dispositif de mémoire à semiconducteurs selon l'une quelconque des revendications 1 à 5, dans lequel le circuit à transistors de sortie de données (13, 12) est un circuit à transistors MOS à canal N (13, 12).

9. Dispositif de mémoire à semiconducteurs selon la revendication 8, dans lequel le circuit tampon de sortie comprend des premier et second circuits de verrouillage (21, 23) pour maintenir un signal de sortie délivré par le circuit à transistor de sortie de données (13, 12), chaque circuit de verrouillage étant constitué de deux inverseurs de telle sorte qu'une sortie d'un inverseur et une entrée de l'autre inverseur sont connectées l'une à l'autre, une sortie du premier circuit de verrouillage (21) étant connectée à une grille d'un transistor (13) situé sur un côté élévateur du circuit à transistor MOS à canal N, et un signal de sortie du second circuit de verrouillage (23) étant connecté à une grille d'un transistor (12) d'un côté abaisseur du circuit à transistors MOS à canal N.

10. Dispositif de mémoire à semiconducteurs selon la revendication 9, dans lequel le circuit tampon de sortie (8) comprend des moyens élévateurs (15) servant à amplifier une tension de grille du transistor (13) situé sur le côté élévateur du transistor MOS à canal N lors d'une opération de sortie avec amplification de données du circuit à transistors de sortie de données (13, 12).

11. Dispositif de mémoire à semiconducteurs selon la revendication 6 ou 8, dans lequel le circuit tampon de sortie (108) comprend des moyens formant circuit (41, 42, 43, 44) pour empêcher un courant traversant dans le circuit à transistor de sortie de données.

12. Dispositif de mémoire à semiconducteurs selon l'une quelconque des revendications précédentes, dans lequel une sortie du circuit à transistors de sortie de données (11, 12; 13, 12) est verrouillée à un niveau intermédiaire d'un niveau logique de sortie, lorsque le circuit à transistors de sortie de données (11, 12; 13, 12) est dans l'état d'impédance élevée.
